(19) Europäisches Patentamt

European Patent Office

Office européen des brevets

(11) Publication number : **0 529 869 A1**

(12) **EUROPEAN PATENT APPLICATION**

(21) Application number : **92307353.0**

(22) Date of filing : **11.08.92**

(51) Int. Cl.⁵ : **C11D 7/50,** C23G 5/032

(30) Priority : **30.08.91 GB 9118629**

(43) Date of publication of application :
**03.03.93 Bulletin 93/09**

(84) Designated Contracting States :
**AT BE CH DE DK ES FR GB IT LI NL SE**

(71) Applicant : **IMPERIAL CHEMICAL INDUSTRIES PLC**
**Imperial Chemical House, Millbank**
**London SW1P 3JF (GB)**

(72) Inventor : **Milne, Neil James**
**"Glenelg", Church Road**
**Saughall, Chester CH1 6ED (GB)**
Inventor : **Mitchell, Christopher John**
**39 Marina Village**
**Runcorn, Cheshire WA7 3BH (GB)**

(74) Representative : **Thomas, Ieuan et al**
**ICI Group Patents Services Dept. PO Box 6**
**Shire Park Bessemer Road**
**Welwyn Garden City Herts, AL7 1HD (GB)**

(54) **Cleaning composition.**

(57)   A cleaning composition comprising one or more aliphatic compounds and one or more lower alcohols having about 8 carbon atoms, preferably 2-ethyl-hexanol, for use in industrial cleaning applications, eg in the electronics industry.

EP 0 529 869 A1

Jouve, 18, rue Saint-Denis, 75001 PARIS

The present invention relates to cleaning compositions, particularly cleaning compositions for use in so-called semi-aqueous cleaning applications in which contaminated articles such as, for example metals, glass, electronic components and printed circuit boards, are contacted with a cleaning composition and the residual cleaning composition is removed from the articles by rinsing in water.

Solvent cleaning applications wherein contaminated articles are immersed in or washed with halogenated hydrocarbon solvents and/or the vapours thereof are well known and are in common use.

It is now widely recognised that certain chlorine-containing compounds, particularly chlorofluorocarbons, may be damaging the ozone layer surrounding the earth and it has been agreed that the manufacture and use thereof should be severely restricted and eventually curtailed.

Non-halogenated solvents, eg terpenes, have been proposed as substitutes for such chlorine-containing compounds in US 4,640,719. However, terpenes are often completely insoluble in water and cannot be directly flushed away from the cleaned article with the rinsing water and it has been further proposed in US 4,640,719 to incorporate one or more emulsifying surfactants with the rinsing water to facilitate removal of the terpene from the article. Recently, mixtures of hydrocarbons and dibasic esters, often in the presence of a so-called compatibilising component, and mixtures of aliphatic hydrocarbons and certain polar organic compounds have been proposed as cleaning solvents for certain applications in EP 0,412,475 and WO 91/06690 respectively. The aforementioned mixtures tend to suffer from certain disadvantages, eg toxicity , flammability, or one or more components thereof cannot be recycled.

We have now invented a non-halogenated cleaning composition suitable for semi-aqueous cleaning applications which is ozone benign, non-corrosive, non-combustible and has low toxicity.

By "non-combustible" we mean that the solvent has a flash point above about 60°C measured by the Tag Closed Cup method.

According to the first aspect of the present invention there is provided a cleaning composition which comprises one or more aliphatic compounds and one or more lower alcohols having about 8 carbon atoms (hereinafter referred to for convenience as "lower alcohol").

The cleaning composition according to the present invention is typically in the form of a solution.

The aliphatic compound has a flash point of more than 60°C and boils in the range 150-250°C, preferably 180-240°C.

The aliphatic compound is preferably an alkane, more preferably a linear alkane and particularly more preferably decane, undecane, dodecane, tridecane or a mixture thereof. We do not exclude the possibility that the aliphatic compound may contain one or more rings, eg it may be a "naphthene" derivative, ie "naphthenic"; however, this is not preferred. Furthermore, where a mixture of aliphatic compounds is used, eg $C_{10-13}$ alkanes, the respective amounts are not considered critical and commercially available alkane mixtures may be used directly.

We do not exclude the possibility that the cleaning composition of the present invention may contain a small amount, up to about 5%w/w say, of an aromatic compound, although this is not preferred.

We do not exclude the possibility that the aliphatic compound may bear one or more substituents which do not unduly inhibit the solvent power of the cleaning composition or unduly decrease its stability to the operational conditions in which the cleaning composition is used.

Preferably the lower alcohol is a primary alcohol, although we do not exclude the possibility that it may be a secondary or tertiary alcohol. More preferably it is 2-ethyl-hexanol.

The lower alcohol has a bp in the range 150-250°C, preferably 180-190°C, is mutually soluble with the aliphatic compound, is not classified as combustible and has less than 2% solubility in water at room temperature.

The use of a lower alcohol having such a water solubility affords the advantage that the cleaning composition may be recovered by steam-distillation after use and recycled.

The concentration or ratio of aliphatic compound and lower alcohol in the cleaning composition according to the present invention may vary within wide limits but the mixture should contain sufficient lower alcohol to render the cleaning composition capable of dissolving at least a proportion of ionic contamination present in solder flux residues from printed circuit boards, where it is used in the preparation thereof.

In the cleaning composition of the present invention the weight ratio of the aliphatic compound to lower alcohol is typically between 50:50 and 90:10 and preferably is about 80:20, particularly where the paraffin is $C_{10-13}$ and the alcohol is 2-ethyl-hexanol, on the weight percent of these components only.

According to a preferred embodiment of the present invention there is provided a cleaning composition which comprises a mixture of $C_{10-13}$ aliphatic compounds and 2-ethyl hexanol wherein the aliphatic compounds and the 2-ethyl hexanol provide 80% w/w and about 20% w/w respectively of the cleaning composition.

We do not exclude the possibility that in addition to the aliphatic compound and the lower alcohol the cleaning composition may contain one or more additives, for example a stabiliser, or a surfactant.

The cleaning composition of the present invention may be used as replacement for the solvents used in any of the known cleaning methods however, vapour degreasing is not a preferred method of use.

The cleaning composition may be used in cold cleaning applications but will typically be employed at an elevated temperature up to its flash point. Cleaning is conveniently carried out at about 20-55°C.

According to the second aspect of the present invention there is provided a process for the cleaning of an article which process comprises the step of contacting the article with the cleaning composition according to the first aspect of the present invention.

The method of contacting the article with the cleaning composition in the process is not critical. For example, the article, or an appropriate portion thereof, may be contacted with the liquid cleaning composition, typically by immersion in a bath thereof. However, we do not exclude the possibility that the article may be subjected to a spray of the cleaning composition or the cleaning composition may flow over the stationary article. In a further embodiment the article is subjected to ultra-sonic radiation or mechanical agitation, eg stirring or vibration, during the contacting step.

The article is removed from contact with the liquid cleaning composition and residual cleaning composition thereon may be caused or allowed to evaporate therefrom. Preferably, however, the "wet" article is rinsed with an aqueous rinsing medium to remove the residual cleaning composition therefrom. Typically, the aqueous rinsing medium is water. Rinsing is conveniently carried out at 20-55°C, eg ambient temperature.

The cleaning composition is preferably recovered from the liquid mixture produced in the rinsing step and recycled. Preferably recovery is effected by steam distillation. The organic fraction is separated from the distillate and the concentration of aliphatic compound and lower alcohol therein is adjusted as necessary.

The distillation step in the process according to the further aspect of the present invention as hereinafter defined is carried out above the flash point of the aliphatic compound and lower alcohol. The other steps in the process are carried out below such flash points.

Preferably the steps of washing, rinsing and steam distillation are carried out in an integral apparatus, for example in an apparatus as described in our EP 0,490,501.

In the apparatus described in our aforementioned EP 0,490,501, the article(s) and the cleaning composition are contacted in a contact zone at a temperature substantially below the flash-point of the cleaning composition; the article(s) bearing the cleaning composition are contacted with an aqueous rinsing medium at a temperature substantially below the flash-point of the cleaning composition;the liquid comprising the cleaning composition and the aqueous rinsing medium is collected from the articles(s); the aforementioned liquid is steam distilled within a fire hazard containment zone; the vapour is condensed; the cleaning composition is separated from the aqueous medium; and the cleaning composition, after adjustment of the concentrations of the components thereof, where necessary, is recycled for contact with further articles.

According to a further aspect of the present invention there is provided a process for the cleaning of contaminated article(s), which process comprises at least the Steps of (A) contacting the article(s) with the cleaning composition as defined in the first aspect of the present invention, (B) contacting the article(s) bearing residual cleaning composition from Step A with an aqueous rinsing medium, (C) collecting the liquid comprising the aqueous rinsing medium and the residual cleaning composition removed thereby from Step B, (D) steam-distilling the liquid collected in Step (C), (E) separating the cleaning composition from the steam-distillate, (F) adjusting the concentrations of the components of the cleaning composition separated in Step (E), where necessary, and (G) recycling the cleaning composition from Step (E) or (F) for contact with further articles.

The present invention is further illustrated by reference to the following Examples.

In the Examples :

Solder Cream A is a proprietary solder cream containing 62% Sn, 38 %Pb, rosin-active flux, alloy particles of size 75-53u with 86% metal content;

Solder Cream B is a proprietary solder cream;

Flux 1 is a proprietary flux of density 0.825 at 20°C, flash point 10°C and 15.2 % w/w solids content;

Flux 2 is a proprietary flux ; and

Flux 3 is a proprietary flux density of 0.823 at 20°C, flash point 12°C and 15% solids content.

In the Examples, Residual Ionics was measured, and is shown in Tables 4-7, as "equivalents of NaCl $(ug/in^2)$". The accepted industry standard is US Military Specification No. 28809 and can be measured using an Omegameter for which the pass/fail value for ionic residues is $14ug/ins^2$.

## Examples 1-7

Examples 1,2,4 and 6 illustrate the capability of cleaning compositions according to the present invention to remove residual flux from a printed circuit board. Examples 3,5 and 7 are Comparative Tests.

## TABLE 1

| Example No | Paraffin | | 2-ethyl-hexanol (Conc w/w %) | % Ionics removed | Comments |
|---|---|---|---|---|---|
| | Identity | Conc % | | | |
| 1 | $C_{10-13}$ | 90 | 10 | 88.5 | Satisfactory appearance |
| 2 | $C_{10-13}$ | 80 | 20 | 88.7 | Satisfactory appearance |
| CT3 | $C_{10-13}$ | 100 | - | 48.0 | Portions of undissolved rosin left on the board |
| 4 | a | 90 | 10 | 87.0 | Satisfactory appearance |
| CT5 | a | 100 | - | 65.0 | Portions of undissolved residue and white residue left on the board |
| 6 | b | 90 | 10 | 91.0 | Satisfactory appearance |
| CT7 | b | 100 | - | 91.0 | Unsatisfactory appearance; portions of undissolved rosin left on the board |

a: branched alkane MW 160; bp 190-207°C.
b: branched alkane MW 142; bp 182-199°C; Naphthenic derived solvent.
CT: Comparative Test.

Copper-clad FR-4 circuit boards were dotted with Solder Cream A and reflowed in an ICI VP 4535 vapour phase solder machine. They were washed in the cleaning composition by immersion for 3 minutes, followed by a rinse in deionised water for 1 minute. The residual ionic contamination was measured using a Protonique Contaminometer.

4

The results are shown in Table 1, from which it can be seen that cleaning compositions according to the present invention are substantially more efficient than neat hydrocarbons at removing ionic solder flux rosin residues from pcb's.

Examples 8-13

These Examples illustrate the hydrolytic stability of cleaning compositions according to the present invention and certain components thereof.

The cleaning composition and the aliphatic components thereof were separately refluxed with deionised water for 7 days with and without the metal test pieces mentioned in Table 2.The non-volatile residue (NVR) and acidity of the cleaning composition and component and the weight change of the test-pieces were measured. The aforementioned measurements and the appearance of the cleaning composition and test-pieces are shown in Table 2, from which it can be seen that the cleaning composition is stable to high temperature boiling and accordingly is suitable for steam distillation recycling.

The dimensions of the test pieces used in these Examples were about 1 cm x 7 cm x 0.3 cm and they weighed between 7 and 25 grams.

Examples 14-16

These Examples illustrate the oxidative stability of components of the cleaning composition according to the present invention.

## TABLE 2

| Example No | Solvent Composition | Metal | Appearance of metal | Wt change of metal (mg) | Appearance of solvent | NVR (% w/w) | Acidity (equiv NaOH/I) |
|---|---|---|---|---|---|---|---|
| 8 | $C_{10}$-$C_{13}$ paraffin/2-ethyl-hexanol (90% w/w/10% w/w) | none | - | - | colourless | | <0.0004 |
| | | s. steel | slight bloom | 9 | colourless | 0.010 | <0.0004 |
| | | Zn | grey coating | 89 | colourless | 0.010 | <0.0004 |
| | | Al | light tarnish | 50 | colourless | 0.005 | <0.0004 |
| | | Cu | light tarnish | 17 | colourless | 0.042 | <0.0004 |
| 9 | $C_{10}$-$C_{13}$ paraffin | none | - | - | colourless | 0.026 | <0.0004 |
| | | s. steel | clean | 11 | colourless | 0.0026 | " |
| | | Zn | white specks | 128 | colourless | 0.018 | " |
| | | Al | darkened | 29 | colourless | 0.0026 | " |
| | | Cu | slight tarnish | -20 | colourless | 0.0026 | " |
| 10 | a/ethyl-hexanol (90% w/w/10% w/w) | none | - | - | colourless | 0.010 | <0.0004 |
| | | s. steel | slight bloom | 11 | colourless | 0.0026 | <0.0004 |
| | | Zn | grey coating | 68 | colourless | 0.018 | <0.0004 |
| | | Al | light tarnish | 47 | colourless | 0.0026 | 0.0246 |
| | | Cu | light tarnish | 21 | colourless | 0.0026 | 0.0238 |

Each component of the cleaning composition was heated at 100°C for 7 days while air (50 ml/min) was bubbled through it. In certain experiments, as shown in Table 3, metal test pieces were present in the component.

The appearance, peroxide value and NVR of the component at the end of the test are shown in Table 3, from which it can be seen that each component is oxidatively stable.

Examples 17-20

Examples 18-20 illustrate further cleaning compositions according to the present invention, and their use in standard screening tests. Example 17 is a Comparative Test.

In Examples 17-20, the cleaning compositions were mixtures of $C_{10-13}$ paraffins and 2-ethyl hexanol (2-EH) having the 2-EH concentrations shown in Table 4.

Dots of Solder Cream A were applied to the copper surface of a copper clad epoxy glass fibre board (7.5cms x 5cms), brass shims (0.006ins thick) were placed on the board and a glass microscope slide was clipped thereto creating a gap (so-called "stand-off") of thickness 0.006 ins between the board and the glass slide. The assembly was reflowed in an ICI VP 4535 vapour phase solder machine and was then immersed in the cleaning composition and stirred for 2 minutes at 45°C. Residual cleaning composition was removed from the board by rinsing with water agitated by air sparging for 2 minute at 35°C and 2 minutes at 50°C. The rinsed board was dried by subjecting it to a stream of compressed air at 20°C.

TABLE 2 (Contd...)

| Example No | Solvent Composition | Metal | Appearance of metal | Wt change of metal (mg) | Appearance of solvent | NVR (% w/w) | Acidity (equiv NaOH/I) |
|---|---|---|---|---|---|---|---|
| 11 | a | none | — | — | colourless | 0.03 | 0.001 |
| | | s. steel | slight bloom | 3 | colourless | 0.104 | <0.0004 |
| | | Zn | grey coating | 67 | colourless | 0.056 | <0.0004 |
| | | Al | light tarnish | 32 | colourless | 0.0099 | <0.0004 |
| | | Cu | light tarnish | 21 | colourless | 0.0245 | <0.0004 |
| 12 | b/ethyl-hexanol (90% w/w/10% w/w) | none | — | — | | | |
| | | Zn | | | | | |
| | | Al | | | | | |
| | | Cu | | | | | |
| 13 | b | none | — | — | red/orange | 0.056 | 0.004 |
| | | Zn | grey coating | 86 | red | 0.018 | <0.0004 |
| | | Al | brown coating | 19 | colourless | 0.103 | <0.0004 |
| | | Cu | tarnished | 65 | pink | 0.111 | 0.0014 |
| | | St. steel | p. brown tarnish | 12 | brown | 0.048 | 0.0007 |

nd: Not determined
a and b: as in Table 1

EP 0 529 869 A1

TABLE 3

| Example No | Solvent | Metal | Peroxide (mmol/kg) | NVR (% w/w) | Appearance of Solvent |
|---|---|---|---|---|---|
| 14 | $C_{10}-C_{13}$ paraffin | none | 0.2 | 0.01 | Colourless |
| | | Cu | 28.8 | 0.27 | Colourless |
| | | Zn | 0.5 | 0.02 | Colourless |
| 15 | 2-Ethyl-hexanol | none | 0.05 | <0.01 | Colourless |
| | | Cu | 0.1 | <0.01 | Colourless |
| | | Zn | <0.05 | <0.01 | Colourless |
| 16 | a | none | <0.05 | 0.12 | Colourless |
| | | Cu | 37.6 | 0.04 | Colourless |
| | | Zn | <0.05 | <0.01 | Colourless |

a: as in Table 1

The results are shown in Table 4 from which it can be seen that a satisfactory product is obtained as assessed by appearance or residual ionics.

EP 0 529 869 A1

Table 4

| Example No. | Conct 2-EH (% w/w) | Product | |
|---|---|---|---|
| | | Appearance of the board | Residual Ionics |
| CT 17 | 0 | Not acceptable | 8.4 |
| 18 | 20 | Acceptable | 8.3 |
| 19 | 40 | Acceptable | 6.9 |
| 20 | 60 | Acceptable | 8.3 |

Examples 21-23

These Examples illustrate the removal of solder fluxes by cleaning compositions according to the present invention.

Dots of solder fluxes were applied to the copper surface of a copper clad epoxy glass fibre board (7.5 cms x 5cms). The board was reflowed in an ICI VP 4535 vapour phase solder machine and was then immersed in the cleaning composition. The cleaning composition was agitated past the stationery board for 2 minutes at 45°C.

The cleaning compostion was a mixture of 2-EH (20% w/w) and $C_{10-13}$ paraffin (80% w/w).

The boards were rinsed and assessed.

The results are shown in Table 5 from which it can be seen that the cleaning composition according to the present invention is effective in removing a variety of solder fluxes.

Table 5

| Example No. | Flux | Product | |
|---|---|---|---|
| | | Appearance | Residual Ionics |
| 21 | Flux 2 | Acceptable | 0.9 |
| 22 | Flux 1 | Acceptable | 9.6 |
| 23 | Flux 3 | Acceptable | 6.2 |

Examples 24-29

These examples illustrate the use of cleaning compositions according to the present invention containing varying amounts of rosin contamination.

Assemblies similar to those used in Examples 17-20 were used for assessing solder cream removal (Examples 25,27 and 29) and boards similar to those used in Examples 21-23 were used for assessing Solder Flux removal (Examples 24,25 and 28). Varying amounts of ground rosin were added to the cleaning composition (20% w/w 2-EH and 80% w/w $C_{10-13}$ paraffins) as indicated in Table 6. The test pieces were immersed in the cleaning composition and the cleaning composition and the was agitated to flow over the test pieces.

The results are shonw in Table 6.

10

Table 6

| Example No. | Rosin Contaminant (% w/w) | Cream/Flux to be removed | Product Residual Ionics |
|---|---|---|---|
| 24 | 2 | Flux 1 | 4.2 |
| 25 | 2 | Solder Cream A | 3.3 |
| 26 | 4 | Flux 1 | 4.3 |
| 27 | 4 | Solder Cream A | 4.5 |
| 28 | 6 | Flux 1 | 5.6 |
| 29 | 6 | Solder Cream A | 3.4 |

From Table 6 it can be seen that the cleaning composition removed ionic contamination to an industry accepted standard in the presence of rosin contaminant.

Examples 30-34

These Examples illustrate the use of cleaning compositions according to the present invention under a variety of washing conditions.

The cleaning composition was 2-EH (20% w/w) and $C_{10-13}$ paraffins (80% w/w).

Table 7

| Example No | Stand-off (ins) | Solder Cream | Washing Procedure | Product | |
|---|---|---|---|---|---|
| | | | | Appearance of Board | Residual Ionics |
| 30 | 0.006 | Solder Cream A | AG | Acceptable | 2.5 |
| 31 | 0.004 | " | AG | " | 3.1 |
| 32 | 0.006 | Solder Cream B | AG | " | 6.2 |
| 33 | 0.006 | Solder Cream A | LS | " | 4.8 |
| 34 | " | " | LS | " | 5.0 |

AG : Agitated

LS : Liquid stirred

For Example 34 the procedure of Example 33 was repeated except that the board was subjected to ultrasound while being rinsed with water.

From Table 7 it can be seen that, with correct washing method acceptable cleaning performance can be obtained.

Examples 35-45

These Examples illustrate the use of cleaning compositions according to the present invention in industrial cleaning applications.

Transmission oil (1.5 mls) was applied to a steel panel (15cms x 5cms), the steel panel was allowed to drain vertically for 5 minutes, a sample of the cleaning composition (5mls) was poured over the panel and it was allowed to drain vertically for 5 minutes. The amount of oil removed was then assessed.

The results are shown in Table 8

Table 8

| Example No. | Cleaning Composition | Oil removed (% w/w) |
|---|---|---|
| 35 | 2-EH(20%):$C_{11-13}$ para (80%) | 35 |
| CT 36 | Methyl chloroform | 0 |
| CT 37 | White Spirit | 40 |

CT's are Comparative Tests

A layer (0.4 microns) of soil (6 parts w/w transmission oil: 3 parts w/w charcoal: 1 part w/w lithium EP1 grease) was applied to a steel panel (15 cms x 5cms). Cleaning composition (10mls) was applied to the soiled panel, the panel was allowed to drain vertically for 2 minutes, allowed to dry and the amount of solvent removed was assessed.

The results are shown in Table 9

Table 9

| Example No. | Cleaning Composition | Soil Removed (% w/w) |
|---|---|---|
| 38 | As Example 35 | 25 |
| CT 39 | Methyl chloroform | 10 |
| CT 40 | White Spirit | 10 |
| CT 41 | Paraffin | 40 |

CT's are Comparative Tests

The procedure of Examples 38-41 was repeated except that 2mls of cleaning composition was used, the panel was then held horizontally for 30 secs and wiped with a tissue under a 500gms load.

The results are shown in Table 10

Table 10

| Example No. | Cleaning Composition | Soil Removed (% w/w) |
|---|---|---|
| 42 | As Example 35 | 60 |
| CT 43 | Methyl chloroform | 25 |
| CT 44 | Paraffin | 25 |
| CT 45 | White Spirit | 60 |

CT's are Comparative Tests

From Tables 8, 9 and 10 it can be seen that the cleaning capability of cleaning compositions according to the present invention is at least as good as known cleaning compositions.

Examples 46-48

These Examples illustrate the use of cleaning composition according to the present invention in further industrial cleaning applications.

Contaminated samples were washed with a cleaning composition comprising 2-EH (20% w/w) and $C_{11-13}$ paraffins (80% w/w) under the conditions shown in Table 11. They were then rinsed with hot water at 55°C and dried in an oven at 60°C (Example 46) or by hot air at 60°C (Examples 47 and 48).

Table 11

| Example No. | Sample | Contaminant | Wash |
|---|---|---|---|
| 46 | Steel bolts | Light oil | 2min/45°C swirl |
| 47 | Brass components | Cutting oil swarf | 5min/45°C stationary |
| 48 | Ceramics | Lapping Paste | 5min/45°C swirl then ultrasonic agitation for 5min/45°C |

Clean dry samples could be obtained from the experiments.

## Claims

1. Cleaning composition comprising one or more aliphatic compounds and one or more lower alcohols having about 8 carbon atoms.

2. A cleaning composition as claimed in Claim 1 wherein the one or more aliphatic compounds comprises one or more alkanes.

3. A cleaning composition as claimed in Claim 2 wherein the one or more alkanes comprises decane, undecane, dodecane, tridecane or a mixture thereof.

4. A cleaning composition as claimed in Claim 1 wherein the lower alcohol has less than 2% solubility in water.

5. A cleaning composition as claimed in Claim 4 wherein the lower alcohol is a primary alcohol.

6. A cleaning composition as claimed in Claim 5 wherein the primary alcohol is 2-ethyl-hexanol.

7. A cleaning composition as claimed in Claim 1 wherein the concentration of lower alcohol is about 20%w/w.

8. A cleaning composition as claimed in Claim 6 wherein the aliphatic compound is a mixture of $C_{10-13}$ aliphatic compounds.

9. A cleaning composition as claimed in Claim 8 wherein the weight ratio of aliphatic compound:2-ethyl hexanol is about 4:1.

10. A process for cleaning an article comprising the step of contacting the article with a cleaning composition as claimed in Claim 1.

11. A process as claimed in Claim 10 comprising the step of rinsing the article bearing residual cleaning composition after removing it from contact with the cleaning composition with an aqueous rinsing medium.

12. A process as claimed in Claim 11 using a cleaning composition as claimed in Claim 4 comprising the step of recovering the cleaning composition from the liquid produced in the rinsing step which comprises cleaning composition and aqueous rinsing medium.

13. A process as claimed in Claim 12 wherein the cleaning composition is recovered by steam distillation.

**European Patent Office**

## EUROPEAN SEARCH REPORT

Application Number

EP    92 30 7353

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | WO-A-9 106 690 (HENKEL KOMMANDITGESELLSCHAFT AUF AKTIEN) * page 4, line 1 - line 4; claims 1,7 * --- | 1-5 | C11D7/50 C23G5/032 |
| X | EP-A-0 330 379 (THE BRITISH PETROLEUM COMPANY) * table 4, system 13 * --- | 1-3 | |
| A | DATABASE WPIL Week 8927, Derwent Publications Ltd., London, GB; AN 89-195726 & JP-A-1 132 694 (ASAHI GLASS K.K.) 25 May 1989 * abstract * ----- | 1-5 | |
| | | | TECHNICAL FIELDS SEARCHED (Int. Cl.5 ) C11D C23G |

The present search report has been drawn up for all claims

| Place of search | Date of completion of the search | Examiner |
|---|---|---|
| THE HAGUE | 03 NOVEMBER 1992 | LOISELET-TAISNE S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)